# EUROPÄISCHE PATENTSCHRIFT

(11) **EP 4 309 003 B1**
(45) Veröffentlichungstag und Bekanntmachung des Hinweises auf die Patenterteilung: **15.04.2026**
(21) Anmeldenummer: 22708121.3
(22) Anmeldetag: 24.02.2022
(51) Int. Cl.: B05B 7/06, G03F 7/20, G02B 27/00, B24C 1/00, B05B 7/08, B05B 15/40, B05B 16/40, B24C 5/04, G02B 13/14

(54) **VERFAHREN ZUM REINIGEN EINER OBERFLÄCHE, REINIGUNGSVORRICHTUNG UND OPTISCHE ANORDNUNG**
METHOD FOR CLEANING A SURFACE, CLEANING DEVICE AND OPTICAL ASSEMBLY
PROCÉDÉ DE NETTOYAGE D'UNE SURFACE, DISPOSITIF DE NETTOYAGE ET ENSEMBLE OPTIQUE

(30) Priorität: 18.03.2021 DE 102021202648
(43) Veröffentlichungstag der Anmeldung: 24.01.2024
(73) Patentinhaber: Carl Zeiss SMT GmbH, 73447 Oberkochen (DE)
(72) Erfinder: NAGEL, Mona, 73431 Aalen (DE); SCHIKORA, Jasmin, 89081 Ulm (DE); PEETERS, Daniel, 73447 Oberkochen (DE)
(74) Vertreter: Kohler Schmid Möbus Patentanwälte
(86) Internationale Anmeldenummer: PCT/EP2022/054681
(87) Internationale Veröffentlichungsnummer: WO 2022/194511

(56) Entgegenhaltungen:
- JP-A- 2001 261 320
- US-A- 5 775 127
- US-A- 6 066 032

## Beschreibung

### Hintergrund der Erfindung

Die Erfindung betrifft ein Verfahren zum Reinigen einer Oberfläche, insbesondere einer Oberfläche eines optischen Elements, umfassend: Bereitstellen eines flüssigen Gases in Form von flüssigem CO2, Erzeugen eines Feststoffs in Form von CO₂-Schnee aus dem flüssigen Gas, bevorzugt durch Expandieren des flüssigen Gases, Ausstoßen des Feststoffs auf die zu reinigende Oberfläche, sowie Filtern von in dem flüssigen Gas enthaltenen Partikeln mit einem Partikelfilter. Die Erfindung betrifft auch eine Reinigungsvorrichtung, umfassend: eine Bereitstellungseinrichtung zum Bereitstellen eines flüssigen Gases in Form von flüssigem CO₂, eine Erzeugungseinrichtung zur Erzeugung eines Feststoffs in Form von CO₂-Schnee aus dem flüssigen Gas, bevorzugt durch Expandieren des flüssigen Gases, sowie eine Ausstoßeinrichtung zum Ausstoßen des Feststoffs auf die zu reinigende Oberfläche, wobei die Bereitstellungseinrichtung mindestens einen Partikelfilter zum Entfernen von in dem flüssigen Gas enthaltenen Partikeln aufweist. Die Erfindung betrifft auch eine optische Anordnung, insbesondere eine EUV-Lithographieanlage, die mindestens eine solche Reinigungsvorrichtung umfasst.

Die Verwendung von CO₂ sowie von anderen Gasen/Flüssigkeiten ermöglicht es, die Oberflächen von Bauteilen zu reinigen, um Kontaminationen, z.B. in Form von Partikeln, von den Oberflächen der Bauteile zu entfernen. Durch die Verwendung von Gasen/Flüssigkeiten können Kontaminationen auch von Vertiefungen oder von Hinterschneidungen entfernt werden. Nach der Durchführung der Reinigung ist eine deutliche Reduktion von angehafteten (makroskopischen) Partikeln an der Oberfläche zu beobachten.

Das Ausstoßen von Feststoffen (als festes Strahlmittel) zur Reinigung von Oberflächen wird u.a. genutzt, um die Oberflächen von optischen Elementen in Lithographieanlagen oder in anderen optischen Anordnungen zu reinigen. Beispielsweise kann zu diesem Zweck CO₂-Schnee verwendet werden, der durch Expandieren von flüssigem CO₂ erzeugt wird. Es ist ebenfalls möglich, CO₂-Pellets für die Reinigung von Oberflächen zu verwenden, die in optischen Anordnungen angeordnet sind.

In der US2010/0025231A1 sind eine Vorrichtung und ein Verfahren zum Reinigen eines optischen Elements einer EUV-Lichtquelle beschrieben. Die Vorrichtung und das Verfahren dienen dazu, gestreutes Material von dem optischen Element zu entfernen. Das gestreute Material wird gemeinsam mit EUV-Strahlung durch ein Plasma gebildet, das durch die Anregung eines Targets mit einem Laserstrahl erzeugt wird. Die Anlagerung des gestreuten Materials, das Partikelgrößen im Nanometerbereich aufweist, wird mit Hilfe einer Reinigungseinrichtung überwunden, die beispielsweise eine Partikelausstoßeinrichtung aufweisen kann, um Partikel in Richtung auf das angelagerte Material auszustoßen, um das angelagerte Material mit Hilfe eines Ausstoßdrucks der Partikel von dem optischen Element abzulösen.

In der US 2011/0188011A1 ist eine optische Baugruppe beschrieben, die in einer Projektionsbelichtungsanlage für die EUV-Lithographie montiert ist. Die optische Baugruppe umfasst mindestens eine Vakuum-Kammer, mindestens ein optisches Element, das eine optische Oberfläche aufweist, die eingerichtet ist, um von einem Nutzstrahlenbündel der Projektionsbelichtungsanlage getroffen zu werden, sowie eine Reinigungsvorrichtung, die eingerichtet ist, die optische Oberfläche zu reinigen. Die Reinigungsvorrichtung kann Reinigungsköpfe aufweisen, die ausgebildet sind, einen Strahl eines Reinigungsmediums auf die optische Oberfläche auszurichten. Bei dem Reinigungsmedium kann es sich um Kohlenstoffdioxid (CO₂) handeln, das aus einer Düse austritt und hierbei expandiert, wobei ein Strahl aus CO₂-Schnee gebildet wird.

In der US2016/0207078A1 ist eine optische Anordnung beschrieben, die ein Gehäuse, eine Vakuumerzeugungseinheit zur Erzeugung eines Vakuums in dem Gehäuse, mindestens eine Oberfläche, die in dem Gehäuse angeordnet ist, sowie eine Reinigungseinrichtung zum Entfernen von an der Oberfläche abgelagerten kontaminierenden Stoffen aufweist. Die Reinigungseinrichtung ist ausgebildet, die abgelagerten kontaminierenden Stoffe durch den Ausstoß von CO₂ in Form von CO₂-Pellets zu entfernen. Bei den CO₂-Pellets handelt es sich um trockene CO₂-Eisstücke, d.h. um Festkörperpartikel mit vergleichsweise großen Durchmessern bzw. mittleren Durchmessern in der Regel in der Größenordnung von Millimetern.

Die JP 2001 261320 A offenbart ein Verfahren der eingangs genannten Art, bei dem das Filtern von in flüssigem CO₂ enthaltenen Partikeln mit einem Sinterfilter erfolgt.

Die US 5,775,127 offenbart die Reinigung einer Oberfläche einer Optik mittels einer Schneestrahlanlage zur Herstellung von CO₂-Schnee. Die Schneestrahlanlage umfasst Partikelfilter zur Reinigung von flüssigem CO₂, mit denen große Partikel aus dem flüssigen CO₂ entfernt werden.

### Aufgabe der Erfindung

Aufgabe der Erfindung ist es, ein Verfahren zur Reinigung einer Oberfläche, eine Reinigungsvorrichtung und eine optische Anordnung bereitzustellen, die eine Oberflächenreinigung mit verbesserter Reinigungswirkung ermöglichen.

### Gegenstand der Erfindung

Diese Aufgabe wird gemäß einem ersten Aspekt gelöst durch ein Verfahren der eingangs genannten Art, bei dem der Partikelfilter eine Rückhalterate von mindestens 0,1 µm, bevorzugt von mindestens 0,05 µm aufweist.

Die Erfinder haben erkannt, dass kommerziell erhältliche flüssige Gase, z.B. flüssiges CO₂, nur im Hinblick auf molekulare Kontaminationen quantifiziert werden. Flüssige Gase werden jedoch in der Regel in großen Stahltanks oder in Stahlflaschen bereitgestellt, deren Oberflächen ungünstig bezüglich der Abgabe von Partikeln ausgelegt sind. Die auf diese Weise bereitgestellten flüssigen Gase können daher (Schmutz-)Partikel enthalten, die sich beim Reinigungsprozess auf die zu reinigende Oberfläche übertragen und wiederum zu einer Kontamination der Oberfläche führen. Zwar ist es grundsätzlich bekannt, CO₂ mit Hilfe eines Sinterfilters zu filtern, um von einer Schneestrahlanlage hervorgerufene Partikel auszufiltern, hierbei werden aber nur vergleichsweise große Partikel mit Durchmessern von mindestens 0,5 µm gefiltert. Eine solche Filterung ist aber unzureichend, um die optische Systemperformance zu erreichen, wenn die Oberflächen von optischen Elementen, speziell von optischen Elementen für die EUV-Lithographie, gereinigt werden sollen.

Problematisch für die Kontamination der Oberfläche sind zwar grundsätzlich alle in dem flüssigen Gas enthaltenen Partikel, da diese bei der Reinigung nicht von der Oberfläche entfernt werden, sondern sich auf der Oberfläche anlagern und diese kontaminieren. Für die Erreichung der optischen Systemperformance ist es aber in der Regel nicht ausreichend, wenn Partikel mit Durchmessern von mehr als 0,1 µm von dem Partikelfilter gefiltert werden.

Erfindungsgemäß wird daher vorgeschlagen, einen Partikelfilter zu verwenden, der das flüssige Gas vor der Anwendung an der Oberfläche aufbereitet und der eine (nominelle) Rückhalterate von mindestens 0,1 µm, bevorzugt von mindestens 0,05 µm aufweist. Der Partikelfilter verhindert somit den Durchtritt von Partikeln, die einen Durchmesser von weniger als 0,1 µm, bevorzugt von weniger als 0,05 µm aufweisen.

Für den Fall, dass die CO₂-Schneestrahlanlage bzw. das Trockeneisstrahlgerät, dem das gefilterte flüssige CO₂ zugeführt wird, partikelfrei ausgelegt sind, kann durch die Vorfilterung des flüssigen Kohlenstoffdioxids eine Reinigung der Oberfläche erfolgen, ohne dass hierbei größere Partikel appliziert werden. Die Partikelfreiheit kann z.B. an den Oberflächen von Wafern mit Hilfe einer Streulichtmessung nachgewiesen werden.

Im Gegensatz dazu lassen sich die Anforderungen für die Filterung von flüssigem CO₂, das für die Reinigung von Oberflächen von optischen Elementen verwendet wird, mit Hilfe von metallischen Filtermaterialien, wie sie in Sinterfiltern eingesetzt werden, in der Regel nicht erfüllen.

Bei einer Variante ist das Filtermedium des Partikelfilters aus einem Kunststoff gebildet, bevorzugt aus PTFE (Polytetrafluoretyhlen), PFA (Perfluoralkoxy-Polymeren), POM (Polyoxymethylenen) oder PET (Polyethylenterephthalat). Diese Materialien ermöglichen das Erreichen von Rückhalteraten von mindestens 0,1 µm bzw. von mindestens 0,05 µm und weisen eine hohe chemische Beständigkeit für aggressive Flüssigkeiten, beispielsweise für flüssiges CO₂ auf.

Bei dem Partikelfilter, genauer gesagt bei dem Filterelement des Partikelfilters, kann es sich beispielsweise um einen Filter handeln, der von der Fa. Pall Corporation unter dem Handelsnamen Emflon^{®} Filter, beispielsweise unter dem Handelsnamen Emflon^{®} PF Filter oder Emflon^{®} PFR Filter angeboten wird. Ein solcher Partikelfilter weist eine PTFE-Membran als Filtermedium auf. Auch die anderen weiter oben beschriebenen Materialien eignen sich als Filtermedien für die Partikelfilterung von flüssigem CO₂. Bei dem Filterelement, das zur Filterung des flüssigen Gases verwendet wird, kann es sich grundsätzlich um einen Flüssigkeitsfilter oder um einen Gasfilter handeln.

Bei einer Variante wird das flüssige Gas in dem Partikelfilter bei einem Druck von mehr als 45 bar, ggf. bei mehr als 60 bar, gefiltert. Der Druck des flüssigen Gases beim Filtern liegt typischerweise in der Größenordnung zwischen 45 bzw. 50 bar und ca. 70 bar. Mit einem Druck in diesem Druckbereich wird das flüssige Gas typischerweise in einem Behälter, beispielsweise in einer Druckgasflasche, bereitgestellt. Der Partikelfilter muss ausgebildet sein, einem derart hohen Druck standzuhalten. Zu diesem Zweck kann der Partikelfilter ein Gehäuse aus Edelstahl aufweisen, das idealerweise elektropoliert ist. Auch das Filterelement bzw. das Filtermaterial des Partikelfilters muss einem derart hohen Druck standhalten, was beispielsweise bei den oben beschriebenen Filtern der Fall ist. Der Partikelfilter wird typischerweise bei Raumtemperatur verwendet und auch das flüssige Gas wird bei Raumtemperatur gelagert.

Bei einer weiteren Variante beträgt ein Volumenstrom des flüssigen Gases durch den Partikelfilter mindestens 200 ml / min. Um eine Reinigung von Oberflächen speziell von optischen Elementen zu ermöglichen, ist es in der Regel erforderlich, dass das flüssige Gas mit einer vergleichsweise großen Flussrate in der oben angegebenen Größenordnung bereitgestellt wird.

Bei einer weiteren Variante wird das flüssige Gas in dem Partikelfilter von einem Filtermedium mit einer Filterfläche von mindestens 0,00625 m² pro Liter des flüssigen Gases gefiltert. Durch das Vorsehen einer ausreichend großen Filterfläche kann das flüssige Gas in SFE ("Superctritical fluid extraction")-Qualität partikelfrei bereitgestellt werden.

Eine ausreichend große Filterfläche pro Liter des flüssigen Gases, das den Partikelfilter durchströmt, ist zudem erforderlich, damit der Partikelfilter dem Druckanstieg von Atmosphärendruck bis auf z.B. 45 bar oder 60 bar bei der Inbetriebnahme standhält. Bei der Zuführung des flüssigen Gases zum Partikelfilter kann in der Regel kein Druckregler verwendet werden, um den Druckanstieg zu kontrollieren, da diese für Steigrohrflaschen ungeeignet sind. Auch bei einer langsamen Öffnung des Ventils zum Kontrollieren des Druckanstiegs ist daher eine vergleichsweise große Filterfläche pro Liter des flüssigen Gases erforderlich, um eine Zerstörung zu verhindern. Das Filtermedium bzw. der Partikelfilter muss zusätzlich auch die Anforderungen an die Flussrate erfüllen, die für eine effiziente Reinigung benötigt wird. Metallische Sinterfilter, die für Drücke von z.B. 45 bar bzw. 60 bar und einem Volumenstrom von mindestens 200 ml /min ausgelegt sind, sind nicht bekannt. Die Erfüllung dieser Anforderungen ist aber in der Regel erforderlich, wenn eine Abscheidung von Partikeln auf der zu reinigenden Oberfläche unterbunden werden soll.

Bei einer Variante des Verfahrens wird der Feststoff oder das flüssige Gas vor dem Ausstoßen zu CO₂-Pellets gepresst. Bei dieser Variante kann der Feststoff, der z.B. in Form von CO₂-Schnee vorliegen kann, mit Hilfe eines Pelletrierers zu Pellets gepresst werden. Für das Pressen zu Pellets weist der Pelletrierer typischerweise einen Kolben oder dergleichen auf. Die Pellets, die beispielsweise Durchmesser zwischen 0,1 mm und 10 mm aufweisen, können nach dem Pelletieren nicht mehr gefiltert werden, um Partikel zu entfernen. Daher ist es erforderlich, das flüssige Gas bereits vor dem Pelletrierer zu filtern. Gleiches gilt, wenn aus dem flüssigen Gas direkt, d.h. ohne eine Umwandlung zu CO₂-Schnee, Pellets gebildet werden.

Bei der Bildung von CO₂-Schnee durch die Expansion von flüssigem CO₂ wird auch gasförmiges CO₂ gebildet, das einen Gasstrom bildet, der auf die zu reinigende Oberfläche ausgerichtet bzw. ausgestoßen wird und den CO₂-Schnee enthält. Dieser Gasstrom ist aber in der Regel für die Durchführung der Reinigung nicht ausreichend.

Bei einer weiteren Variante umfasst das Verfahren: Mischen des aus dem flüssigen Gas erzeugten Feststoffs mit einem Gas zum Bilden eines Gasstroms, sowie Ausstoßen des Gasstroms auf die zu reinigende Oberfläche. Bei dieser Variante wird der Feststoff, beispielsweise der CO₂-Schnee oder die CO₂-Pellets, mit einem (zusätzlichen) Gas gemischt. Bei dem Gas kann es sich grundsätzlich um ein beliebiges Gas handeln, beispielsweise um ein inertes Gas, z.B. um Stickstoff, es ist aber auch möglich, dass es sich bei dem Gas um (gereinigte) Druckluft handelt.

Beim Schneestrahlen mit CO₂-Schnee unter Verwendung eines zusätzlichen Gases, z.B. von Druckluft, welches dem CO₂-Schnee beigemischt wird, werden zwei Varianten unterschieden: Bei der ersten Variante wird eine Zweistoffringdüse, bei der zweiten Variante eine Strahldüse mit Agglomerationskammer für die Mischung bzw. die Bildung des Gasstroms verwendet. Bei der Zweistoffringdüse wird das flüssige Kohlenstoffdioxid am Düsenaustritt auf Umgebungsdruck entspannt. Die entstehenden CO₂-Schneepartikel werden durch einen Mantelstrahl aus überschallschneller Druckluft gebündelt und beschleunigt. In diesem Fall erfolgt das Ausstoßen und das Mischen am Austritt der Zweistoffringdüse. Bei der Strahldüse mit der Agglomerationskammer wird das flüssige Kohlenstoffdioxid dem Druckluftstrom in einem Entspannungsraum, der so genannten Agglomerationskammer, zudosiert. Im Vergleich zur Zweistoffringdüse entstehen größere Schneepartikel, die mit der Druckluft in einer nachfolgenden Düse beschleunigt werden und zu einer deutlich höheren Abrasivität führen.

Ein weiterer Aspekt der Erfindung betrifft eine Reinigungsvorrichtung der eingangs genannten Art, bei welcher der Partikelfilter eine Rückhalterate von mindestens 0,1 µm, bevorzugt von mindestens 0,05 µm aufweist. Wie weiter oben beschrieben wurde, ermöglicht eine solche Reinigungsvorrichtung eine Reinigung einer Oberfläche, z.B. eines optischen Elements, von (großen) Partikeln, die zur Erfüllung der Spezifikation ausreichend ist.

Bei einer Ausführungsform ist das Filtermedium des Partikelfilters aus einem Kunststoff gebildet, bevorzugt aus PTFE, PFA, POM oder PET. Filtermaterialien aus Kunststoff, insbesondere die oben beschriebenen Filtermaterialien, weisen eine hohe chemische Beständigkeit für aggressive Flüssigkeiten, beispielsweise für flüssiges CO₂ auf und ermöglichen die Realisierung der angegebenen Rückhalteraten.

Bei einer weiteren Ausführungsform weist der Partikelfilter ein Gehäuse, bevorzugt ein Edelstahl-Gehäuse, und ein Filterelement auf, die für einen Druck von mindestens 45 bar ausgelegt sind. Das Edelstahl-Gehäuse ist bevorzugt elektropoliert. Bei dem Gehäuse kann es sich beispielsweise um eine Gehäuse der Fa. Donaldson handeln, vgl. den Link "https://www.donaldson.com/content/dam/donaldson/compressed-air-andprocess/literature/emea/compressed-air-and-gas/filterhousings/industrial/hd/f119007/ger/HD-Hochdruckfilter-fur-industrielle-Anwendungen.pdf" oder um ein Gehäuse wie RATF002GVM8 der Firma Pall Corporation. Das dort beschriebene Gehäuse kann auch zur Filterung von Flüssigkeiten verwendet werden. Bei dem Filterelement kann es sich beispielsweise um eines der weiter oben beschriebenen Filterelemente der Fa. Pall Corporation handeln.

Bei einer weiteren Ausführungsform ist der Partikelfilter für einen Volumenstrom des flüssigen Gases von mindestens 200 ml / min ausgelegt. Ein solcher Volumenstrom ist in der Regel erforderlich, um die Oberflächen von optischen Elementen effektiv zu reinigen.

Bei einer weiteren Ausführungsform weist der Partikelfilter ein Filtermedium mit einer Filterfläche von mindestens 0,00625 m² pro Liter des flüssigen Gases auf. Wie weiter oben beschrieben wurde, kann bei einer derart dimensionierten Filterfläche flüssiges CO₂ in partikelfreier SFE-Qualität bereitgestellt werden.

Bei einer Ausführungsform weist die Reinigungsvorrichtung einen Pelletrierer zum Pressen des Feststoffs oder des flüssigen Gases zu CO₂-Pellets auf. Der Pelletrierer dient zum Pressen der Pellets aus CO₂-Schnee oder aus flüssigem CO₂. In diesem Fall bildet die Reinigungsvorrichtung ein Trockeneisstrahlgerät. Alternativ kann es sich bei der Reinigungsvorrichtung um eine CO₂-Schneestrahlanlage handeln, bei welcher der CO₂-Schnee nicht zu Pellets gepresst, sondern direkt in Richtung auf die Oberfläche ausgestoßen wird.

Bei einer weiteren Ausführungsform umfasst die Reinigungsvorrichtung eine Mischeinrichtung zur Mischung des aus dem flüssigen Gas erzeugten Feststoffs mit einem Gas zum Bilden eines Gasstroms, wobei die Ausstoßeinrichtung ausgebildet ist, den Gasstrom mit dem darin enthaltenen Feststoff auf die zu reinigende Oberfläche auszustoßen.

Es ist möglich, dass die Erzeugungseinrichtung eine Kapillare bildet, die von dem flüssigen Gas durchströmt wird und an deren austrittseitigem Ende die Expansion des flüssigen Gases erfolgt. Dies ist typischerweise bei einer Zweistoffringdüse der Fall, welche eine Mischungseinrichtung bildet, die einen Gasstrahl aus in der Regel überschallschnellem Gas erzeugt, der die entstehenden Feststoff-Partikel bündelt und beschleunigt. In diesem Fall erfolgt das Ausstoßen und das Mischen an der Austrittsöffnung der Zweistoffringdüse.

Alternativ ist es möglich, das flüssige Gas einem Entspannungsraum (Agglomerationskammer) einer Strahldüse zuzudosieren, dem auch das Gas zugeführt wird, um den in dem Entspannungsraum gebildeten Feststoff und das Gas zu mischen. Eine nach der Stahldüse angeordnete weitere Düse kann den Gasstrom bzw. die darin enthaltenen Feststoff-Partikel ggf. zusätzlich beschleunigen.

Ein weiterer Aspekt der Erfindung betrifft eine optische Anordnung, insbesondere eine EUV-Lithographieanlage, umfassend: mindestens eine Oberfläche, die bevorzugt an einem optischen Element gebildet ist, sowie mindestens eine Reinigungsvorrichtung, die wie weiter oben beschrieben ausgebildet ist, zum Reinigen der Oberfläche. In diesem Fall kann die Reinigung der Oberfläche in-situ, d.h. im Einbauzustand in der optischen Anordnung, erfolgen. Die Reinigung erfolgt typischerweise während einer Betriebspause der optischen Anordnung. Mit Hilfe der Reinigungsvorrichtung können insbesondere die Oberflächen von reflektierenden optischen Elementen, beispielsweise von Spiegeln, von Partikeln gereinigt werden, es ist aber auch möglich, die Oberflächen von anderen Bauteilen, z.B. von Wafern, Masken oder dergleichen, mit Hilfe der Reinigungseinrichtung zu reinigen. Die Partikelfreiheit der Oberfläche kann mit Hilfe einer Streulichtmessung in der Art einer Inspektion einer Maske bzw. eines Wafers nachgewiesen werden.

Es versteht sich, dass die Reinigungsvorrichtung nicht zwingend in eine optische Anordnung integriert werden muss. Die Reinigungsvorrichtung kann grundsätzlich auch dazu verwendet werden, z.B. gefasste oder beschichtete Bauteile sowie Elektroboards und andere Bauteile zu reinigen, insbesondere wenn diese nicht ultraschallgereinigt werden können.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: schematisch im Meridionalschnitt eine Projektionsbelichtungsanlage für die EUV-Projektionslithografie;
- Fig. 2: eine schematische Darstellung einer Reinigungsvorrichtung zur Reinigung einer Oberfläche eines optischen Elements der Projektionsbelichtungsanlage, die eine Ausstoßeinrichtung zum Ausstoßen eines Feststoffs sowie eine Bereitstellungseinrichtung zur Bereitstellung eines flüssigen Gases aufweist,
- Fig. 3a,b: schematische Darstellungen des ausgestoßenen Feststoffs in Form von CO₂-Schnee bzw. in Form von CO₂-Pellets.
- Fig. 4: eine schematische Darstellung der Bereitstellungseinrichtung von Fig. 2 mit einem Partikelfilter zur Filterung von Partikeln, die in flüssigem CO₂ enthalten sind.

In der folgenden Beschreibung der Zeichnungen werden für gleiche bzw. funktionsgleiche Bauteile identische Bezugszeichen verwendet.

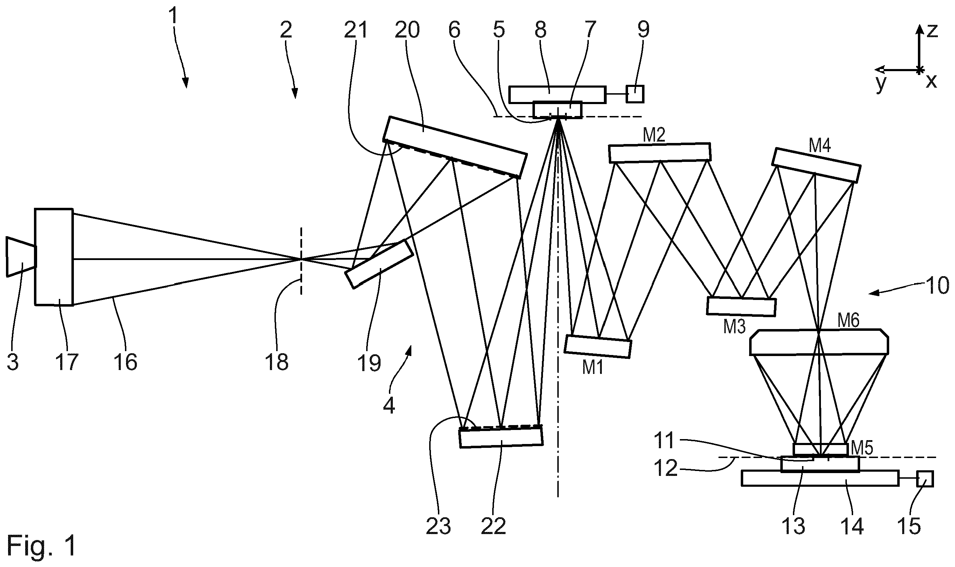

Im Folgenden werden unter Bezugnahme auf Fig. 1 exemplarisch die wesentlichen Bestandteile einer optischen Anordnung für die EUV-Lithographie in Form einer Projektionsbelichtungsanlage 1 für die Mikrolithographie beschrieben. Die Beschreibung des grundsätzlichen Aufbaus der Projektionsbelichtungsanlage 1 sowie von deren Bestandteilen ist hierbei nicht einschränkend zu verstehen.

Eine Ausführung eines Beleuchtungssystem 2 der Projektionsbelichtungsanlage 1 hat neben einer Licht- bzw. Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Beleuchtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

Eine Ausführung eines Beleuchtungssystems 2 der Projektionsbelichtungsanlage 1 hat neben einer Licht- bzw. Strahlungsquelle 3 eine Beleuchtungsoptik 4 zur Beleuchtung eines Objektfeldes 5 in einer Objekt-ebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

In Fig. 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst ein Projektionssystem 10. Das Projektionssystem 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektorspiegel 17 gebündelt. Bei dem Kollektorspiegel 17 kann es sich um einen Kollektorspiegel mit einer oder mit mehreren ellipsoidalen und/oder hyperboloiden Reflexionsflächen handeln. Die mindestens eine Reflexionsfläche des Kollektorspiegels 17 kann im streifenden Einfall (Grazing Incidence, Gl), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektorspiegel 17 kann einerseits zur Optimierung seiner Reflektivität für die Nutzstrahlung und andererseits zur Unterdrückung von Falschlicht strukturiert und/oder beschichtet sein.

Nach dem Kollektorspiegel 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektorspiegel 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt. Im Strahlengang der Beleuchtungsoptik 4 ist dem ersten Facettenspiegel 20 nachgeordnet ein zweiter Facettenspiegel 22. Der zweite Facettenspiegel 22 umfasst eine Mehrzahl von zweiten Facetten 23.

Die Beleuchtungsoptik 4 bildet somit ein doppelt facettiertes System. Dieses grundlegende Prinzip wird auch als Wabenkondensor (Fly's Eye Integrator) bezeichnet. Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Das Projektionssystem 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst das Projektionssystem 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei dem Projektionssystem 10 handelt es sich um eine doppelt obskurierte Optik. Die Projektionsoptik 10 hat eine bildseitige numerische Apertur, die größer ist als 0,4 oder 0,5 und die auch größer sein kann als 0,6 und die beispielsweise 0,7 oder 0,75 betragen kann.

Die Spiegel Mi können, genauso wie die Spiegel der Beleuchtungsoptik 4, eine hoch reflektierende Beschichtung für die Beleuchtungsstrahlung 16 aufweisen.

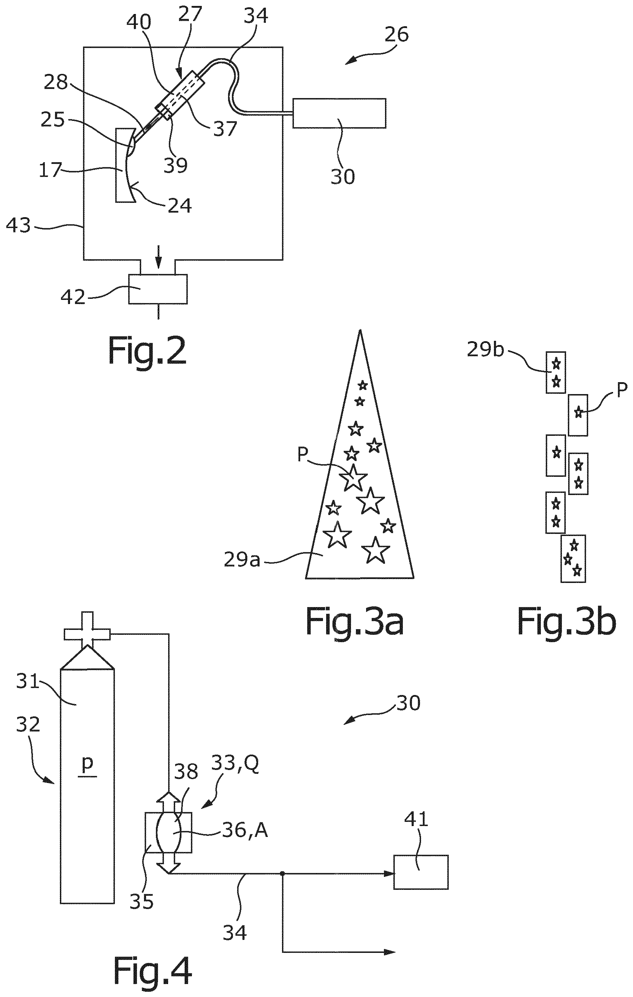

An den optischen Elementen 17, 19, 20, 22 der Beleuchtungsoptik 4 und an den Spiegeln Mi der Projektionsoptik 10 können sich Kontaminationen z.B. in Form von großen Partikeln anlagern. Fig. 2 zeigt beispielhaft ein solches optisches Element in Form des Kollektorspiegels 17, der eine Oberfläche 24 zur Reflexion von Nutzstrahlung aufweist. An der Oberfläche 24 ist beispielhaft ein angelagerter Partikel 25 dargestellt, der einen Durchmesser von mehr als 0,1 µm aufweist. Zur Reinigung der Oberfläche 24 weist die Projektionsbelichtungsanlage 1 eine Reinigungsvorrichtung 26 auf. Die Reinigungsvorrichtung 26 umfasst eine Ausstoßeinrichtung 27 zum Ausstoßen eines (granularen) Feststoffs (bzw. von Feststoff-Partikeln), der in einem Gasstrom 28 auf die Oberfläche 24 ausgestoßen wird.

Bei der in Fig. 2 gezeigten Reinigungsvorrichtung 26 handelt es sich bei den ausgestoßenen Feststoff entweder um CO₂-Schnee 29a, wie er in Fig. 3a dargestellt ist, oder um CO₂-Pellets 29b, wie sie in Fig. 3b dargestellt sind. Auf die Darstellung des Gasstroms 28, in dem der CO₂-Schnee 29a bzw. die CO₂-Pellets 29b geführt bzw. mitgenommen werden, wurde in der Darstellung von Fig. 3a,b verzichtet.

Bei einer herkömmlichen Reinigungsvorrichtung 26 ist der CO₂-Schnee 29a bzw. sind die CO₂-Pellets 29b mit Partikeln P verunreinigt, die Partikelgrößen aufweisen, die kleiner sind als die kontaminierenden Partikel 25 an der Oberfläche 24 des optischen Elements 17. Diese Partikel P können beispielsweise Partikeldurchmesser von weniger als 0,1 µm aufweisen. Bei der Reinigung der Oberfläche 24 von großen Partikeln 25 können sich die kleinen Partikel P, die in dem CO₂-Schnee 29a bzw. in den CO₂-Pellets 29b enthalten sind, an der Oberfläche 24 anlagern, d.h. die Partikel P werden bei der Reinigung auf die zu reinigende Oberfläche 24 übertragen und kontaminieren diese.

Um dies zu vermeiden, weist die Reinigungsvorrichtung 26 eine Bereitstellungseinrichtung 30 zur Bereitstellung von flüssigem CO₂ 31 auf, wie sie in Fig. 4 dargestellt ist. Die Bereitstellungseinrichtung 30 umfasst einen Behälter in Form einer Druckgasflasche 32, in der das flüssige CO₂ gelagert ist. Die Bereitstellungseinrichtung 30 weist auch einen Partikelfilter 33 auf, der in einer Zuführungsleitung 34 der Bereitstellungseinrichtung 30 angeordnet ist.

Der Partikelfilter 33 ist ausgebildet, das flüssige CO₂ 31 zu filtern und weist eine Rückhalterate von mindestens 0,1 µm, im gezeigten Beispiel von ca. 0,05 µm auf. Dies bedeutet, dass von dem Partikelfilter 33 Partikel P zurückgehalten werden, die einen Durchmesser von mehr als 0,05 µm aufweisen. Auf diese Weise kann verhindert werden, dass die Oberfläche 24 bei der Reinigung durch Partikel P kontaminiert wird, die Durchmesser vom mehr als 50 nm aufweisen. Auf diese Weise kann eine Reinigung der Oberfläche 24 erfolgen, ohne dass es hierbei zur Kontamination von in dem CO₂-Schnee 29a bzw. in den CO₂-Pellets 29b enthaltenen Partikeln P kommt.

Das flüssige CO₂ wird in der Druckgasflasche 32 im gezeigten Beispiel mit einem Druck p von ca. 50 bar aufbewahrt. Der Partikelfilter 33 muss diesem Druck p bzw. Drücken in einem Bereich von üblicherweise zwischen ca. 40 bar oder 45 bar und ca. 70 bar standhalten. Zu diesem Zweck weist der Partikelfilter 33 ein Gehäuse 35 aus Edelstahl auf, das elektropoliert ist. Ein geeignetes Hochdruck-Gehäuse 35 wird beispielsweise unter dem oben angegebenen Link von der Fa. Donaldson angeboten.

Der Partikelfilter 33 weist auch ein Filterelement 38 mit einem Filtermedium 36 auf, bei dem es sich im gezeigten Beispiel um einen Kunststoff, genauer gesagt um PTFE handelt. PTFE als Material für das Filtermedium 36 hat den Vorteil, dass dieses Material eine hohe chemische Beständigkeit für aggressive Flüssigkeiten aufweist und daher dem flüssigen CO₂ 31 standhält. Das Filtermedium 36 kann aber auch aus einem anderen (Kunststoff-)Material gebildet sein, das eine hohe chemische Beständigkeit für aggressive Flüssigkeiten, z.B. für CO₂, aufweist, beispielsweise PFA, POM oder PET.. Bei dem Filterelement 38 kann es sich beispielsweise um einen der oben beschriebenen Filter der Fa. Pall Corporation handeln.

Im gezeigten Beispiel ist der Partikelfilter für einen Volumenstrom Q des flüssigen Gases von mindestens 200 ml / min ausgelegt. Dies ist typischerweise erforderlich, um die Oberfläche 24 effektiv zu reinigen.

Um flüssiges CO₂ 31 in SFE-Qualität zu erzeugen, weist das Filtermedium 36 im gezeigten Beispiel eine Filterfläche A von mindestens 0,00625 m² pro Liter flüssigem CO₂ 31 auf. Das gefilterte flüssige CO₂ 31 wird von der Bereitstellungseinrichtung 30 über die Zuführungsleitung 34 der Ausstoßeinrichtung 27 zugeführt. In der Ausstoßeinrichtung 27 wird das flüssige CO₂ in einer Kapillare geführt, die bzw. deren austrittseitiges Ende, als Erzeugungseinrichtung 37 dient, um das flüssige CO₂ 31 beim Austritt in die Umgebung zu entspannen und hierbei den CO₂-Schnee 29a zu erzeugen.

Bei dem in Fig. 2 gezeigten Beispiel weist die Ausstoßeinrichtung 27 auch eine Mischeinrichtung 39 auf, die als Zweistoffringdüse ausgebildet ist. Die Zweistoffringdüse 39 mischt an ihrem Düsenaustritt den CO₂-Schnee 29a mit einem Gas 40, beispielsweise mit gereinigter Druckluft, welches die Kapillare 37 ringförmig umgibt und am Austritt der Zweistoffringdüse 39 einen Mantelstrahl aus überschallschneller Druckluft bildet, welche den CO₂-Schnee 29a bündelt und in Richtung auf die zu reinigende Oberfläche 24 beschleunigt.

An Stelle einer Zweistoffringdüse 39 kann für die Mischung auch eine Strahldüse verwendet werden, die einen Entspannungsraum (Agglomerationskammer) aufweist, um das flüssige CO₂ 31 zu expandieren. In diesem Fall wird der Agglomerationskammer das Gas 40 zugeführt, um den bei der Expansion in der Agglomerationskammer gebildeten CO₂-Schnee 29a mit dem Gas 40 zu mischen. Eine nach der (nicht bildlich dargestellten) Strahldüse angeordnete weitere Düse kann die Ausstoßeinrichtung 27 bilden, um den auf diese Weise erzeugten Gasstrom 28 auf die Oberfläche 24 zu beschleunigen.

Alternativ ist es auch möglich, das flüssige CO₂ einem Pelletrierer 41 zuzuführen, der zunächst CO₂-Schnee 29a bildet und diesen nachfolgend zu CO₂-Pellets 29b presst oder direkt aus dem flüssigen CO₂ 31 die CO₂-Pellets 29b erzeugt, wie dies in Fig. 4 angedeutet ist. Die CO₂-Pellets 29b werden wie der CO₂-Schnee 29a mit einem Gas 40, typischerweise mit Druckluft, in einer nicht bildlich dargestellten Mischeinrichtung gemischt und von der Ausstoßeinrichtung 27 in einem Gasstrom 28 in Richtung auf die zu reinigende Oberfläche 24 ausgestoßen.

Die bei der Reinigung abgelösten Partikel 25 bzw. Kontaminationen können mit Hilfe einer Vakuum-Pumpe 42 aus einer Vakuum-Kammer 43 abgesaugt werden, in der das optische Element in Form des Kollektorspiegels 17 angeordnet ist.

Es versteht sich, dass die Reinigungseinrichtung 26 nicht zwingend in die Projektionsbelichtungsanlage 1 integriert sein muss. Die Reinigungseinrichtung 26 kann insbesondere auch zur Reinigung von Oberflächen 24 von anderen Bauteilen als optischen Elementen eingesetzt werden, beispielsweise wenn eine Ultraschall-Reinigung dieser Bauteile nicht möglich ist.

## Patentansprüche

1. Verfahren zum Reinigen einer Oberfläche (24), insbesondere einer Oberfläche (24) eines optischen Elements (17), umfassend:
Bereitstellen eines flüssigen Gases (31) in Form von flüssigem CO₂,
Erzeugen eines Feststoffs (29a, 29b) in Form von CO₂-Schnee (29a) aus dem flüssigen Gas (31), bevorzugt durch Expandieren des flüssigen Gases (31),
Ausstoßen des Feststoffs (29a, 29b) auf die zu reinigende Oberfläche (24), sowie
Filtern von in dem flüssigen Gas (31) enthaltenen Partikeln (P) mit einem Partikelfilter (33),
**dadurch gekennzeichnet,**
**dass** der Partikelfilter (33) eine Rückhalterate von mindestens 0,1 µm,
bevorzugt von mindestens 0,05 µm aufweist.

2. Verfahren nach Anspruch 1, bei dem ein Filtermedium (36) des Partikelfilters (33) aus einem Kunststoff gebildet ist, bevorzugt aus PTFE, PFA, POM oder PET.

3. Verfahren nach Anspruch 1 oder 2, bei dem das flüssige Gas (31) in dem Partikelfilter (33) bei einem Druck (p) von mehr als 45 bar gefiltert wird.

4. Verfahren nach einem der vorhergehenden Ansprüche, bei dem ein Volumenstrom (Q) des flüssigen Gases (31) durch den Partikelfilter (33) mindestens 200 ml / min beträgt.

5. Verfahren nach einem der vorhergehenden Ansprüche, bei dem das flüssige Gas (31) von dem Partikelfilter (33) in einem Filtermedium (36) mit einer Filterfläche (A) von mindestens 0,00625 m² pro Liter des flüssigen Gases (31) gefiltert wird.

6. Verfahren nach einem der vorhergehenden Ansprüche, bei dem der Feststoff (29a) oder das flüssige Gas (31) vor dem Ausstoßen zu CO₂-Pellets (29b) gepresst wird.

7. Verfahren nach einem der vorhergehenden Ansprüche, weiter umfassend: Mischen des aus dem flüssigen Gas (31) erzeugten Feststoffs (29a, 29b) mit einem Gas (40) zum Bilden eines Gasstroms (28), sowie Ausstoßen des Gasstroms (28) auf die zu reinigende Oberfläche (24).

8. Reinigungsvorrichtung (26) zum Reinigen von Oberflächen (24), insbesondere von Oberflächen (24) von optischen Elementen (17), umfassend:
eine Bereitstellungseinrichtung (30) zum Bereitstellen eines flüssigen Gases (31) in Form von flüssigem CO₂,
eine Erzeugungseinrichtung (37) zum Erzeugen eines Feststoffs (29a, 29b) in Form von CO₂-Schnee (29a), aus dem flüssigen Gas (31), bevorzugt durch Expandieren des flüssigen Gases (31), sowie
eine Ausstoßeinrichtung (27) zum Ausstoßen des Feststoffs (29a, 29b) auf die zu reinigende Oberfläche (24),
wobei
die Bereitstellungseinrichtung (30) mindestens einen Partikelfilter (33) zum Entfernen von in dem flüssigen Gas (31) enthaltenen Partikeln (P) aufweist,
**dadurch gekennzeichnet,**
**dass** der Partikelfilter (33) eine Rückhalterate von mindestens 0,1 µm,
bevorzugt von mindestens 0,05 µm aufweist.

9. Reinigungsvorrichtung nach Anspruch 8, bei dem ein Filtermedium (36) des Partikelfilters (33) aus einem Kunststoff gebildet ist, bevorzugt aus PTFE, PFA, POM oder PET.

10. Reinigungsvorrichtung nach einem der Ansprüche 8 oder 9, bei welcher der Partikelfilter (33) ein Gehäuse (35), bevorzugt ein Edelstahl-Gehäuse, und ein Filterelement (38) aufweist, die für einen Druck (p) von mindestens 45 bar ausgelegt sind.

11. Reinigungsvorrichtung nach einem der Ansprüche 8 bis 10, bei dem der Partikelfilter (33) für einen Volumenstrom (Q) des flüssigen Gases (31) von mindestens 200 ml / min ausgelegt ist.

12. Reinigungsvorrichtung nach einem der Ansprüche 8 bis 11, bei welcher der Partikelfilter (33) ein Filtermedium (36) mit einer Filterfläche (A) von mindestens 0,00625 m² pro Liter des flüssigen Gases (31) aufweist.

13. Reinigungsvorrichtung nach einem der Ansprüche 8 bis 12, weiter umfassend:
einen Pelletrierer (41) zum Pressen des Feststoffs (29a) oder des flüssigen Gases (31) zu CO₂-Pellets (29b).

14. Reinigungsvorrichtung nach einem der Ansprüche 8 bis 13, weiter umfassend:
eine Mischeinrichtung (39) zur Mischung des aus dem flüssigen Gas (31) erzeugten Feststoffs (29a, 29b) mit einem Gas (40) zum Bilden eines Gasstroms (28), wobei die Ausstoßeinrichtung (27) ausgebildet ist, den Gasstrom (28) mit dem darin enthaltenen Feststoff (29a, 29b) auf die zu reinigende Oberfläche (24) auszustoßen.

15. Optische Anordnung, insbesondere EUV-Lithographieanlage (1), umfassend:
mindestens eine Oberfläche (24), die bevorzugt an einem optischen Element (17) gebildet ist,
sowie mindestens eine Reinigungsvorrichtung (26) nach einem der Ansprüche 8 bis 14 zum Reinigen der Oberfläche (24).

## Claims

1. Method for cleaning a surface (24), in particular a surface (24) of an optical element (17), comprising:
providing a liquid gas (31) in the form of liquid CO₂,
generating a solid (29a, 29b) in the form of CO₂ snow (29a) from the liquid gas (31), preferably by expansion of the liquid gas (31),
ejecting the solid (29a, 29b) onto the surface (24) to be cleaned, and
filtering of particles (P) contained in the liquid gas (31) by means of a particle filter (33),
**characterized**
**in that** the particle filter (33) has a retention rate of at least 0.1 µm, preferably of at least 0.05 µm.

2. Method according to Claim 1, wherein a filter medium (36) of the particle filter (33) is formed from a plastic, preferably from PTFE, PFA, POM or PET.

3. Method according to Claim 1 or 2, wherein the liquid gas (31) is filtered in the particle filter (33) at a pressure (p) of more than 45 bar.

4. Method according to one of the preceding claims, wherein a volume stream (Q) of the liquid gas (31) through the particle filter (33) is at least 200 mL/min.

5. Method according to one of the preceding claims, wherein the liquid gas (31) is filtered by the particle filter (33) in a filter medium (36) having a filter area (A) of at least 0.00625 m² per litre of the liquid gas (31).

6. Method according to one of the preceding claims, wherein the solid (29a) or the liquid gas (31) is pressed to form CO₂ pellets (29b) prior to the ejection.

7. Method according to one of the preceding claims, further comprising:
mixing the solid (29a, 29b) generated from the liquid gas (31) with a gas (40) to form a gas stream (28), and
ejecting the gas stream (28) onto the surface (24) to be cleaned.

8. Cleaning apparatus (26) for cleaning surfaces (24), in particular surfaces (24) of optical elements (17), comprising:
a providing device (30) for providing a liquid gas (31) in the form of liquid CO₂,
a generating device (37) for generating a solid (29a, 29b) in the form of CO₂ snow (29a) from the liquid gas (31), preferably by expansion of the liquid gas (31), and
an ejecting device (27) for ejecting the solid (29a, 29b) onto the surface (24) to be cleaned,
wherein
the providing device (30) comprises at least one particle filter (33) for removing particles (P) contained in the liquid gas (31),
**characterized**
**in that** the particle filter (33) has a retention rate of at least 0.1 µm, preferably of at least 0.05 µm.

9. Cleaning apparatus according to Claim 8, wherein a filter medium (36) of the particle filter (33) is formed from a plastic, preferably from PTFE, PFA, POM or PET.

10. Cleaning apparatus according to either of Claims 8 or 9, wherein the particle filter (33) comprises a housing (35), preferably a stainless steel housing, and a filter element (38), which are designed for a pressure (p) of at least 45 bar.

11. Cleaning apparatus according to one of Claims 8 to 10, wherein the particle filter (33) is designed for a volume stream (Q) of the liquid gas (31) of at least 200 mL/min.

12. Cleaning apparatus according to one of Claims 8 to 11, wherein the particle filter (33) comprises a filter medium (36) having a filter area (A) of at least 0.00625 m² per litre of the liquid gas (31).

13. Cleaning apparatus according to one of Claims 8 to 12, further comprising:
a pelletizer (41) for the pressing of the solid (29a) or of the liquid gas (31) to form CO₂ pellets (29b).

14. Cleaning apparatus according to one of Claims 8 to 13, further comprising:
a mixing device (39) for mixing the solid (29a, 29b) generated from the liquid gas (31) with a gas (40) to form a gas stream (28), the ejecting device (27) being configured to eject the gas stream (28) with the solid (29a, 29b) contained therein onto the surface (24) to be cleaned.

15. Optical arrangement, in particular an EUV lithography apparatus (1), comprising:
at least one surface (24) which is preferably formed on an optical element (17),
and at least one cleaning apparatus (26) according to one of Claims 8 to 14 for cleaning the surface (24).

## Revendications

1. Procédé de nettoyage d'une surface (24), en particulier d'une surface (24) d'un élément optique (17), consistant à :
fournir un gaz liquéfié (31) sous forme de CO₂ liquéfié, produire un solide (29a, 29b) sous forme de neige de CO₂ (29a) à partir du gaz liquéfié (31), de préférence par détente du gaz liquéfié (31),
décharger le solide (29a, 29b) sur la surface (24) à nettoyer, et
filtrer des particules (P) contenues dans le gaz liquéfié (31) au moyen d'un filtre à particules (33),
**caractérisé**
**en ce que** le filtre à particules (33) présente un taux de rétention d'au moins 0,1 µm, de préférence d'au moins 0,05 µm.

2. Procédé selon la revendication 1, dans lequel un milieu filtrant (36) du filtre à particules (33) est formé d'une matière plastique, de préférence de PTFE, PFA, POM ou PET.

3. Procédé selon la revendication 1 ou 2, dans lequel le gaz liquéfié (31) du filtre à particules (33) est filtré à une pression (p) supérieure à 45 bars.

4. Procédé selon l'une quelconque des revendications précédentes, dans lequel un débit volumique (Q) du gaz liquéfié (31) à travers le filtre à particules (33) est d'au moins 200 ml/min.

5. Procédé selon l'une quelconque des revendications précédentes, dans lequel le gaz liquéfié (31) est filtré par le filtre à particules (33) dans un milieu filtrant (36) ayant une surface filtrante (A) d'au moins 0,00625 m² par litre de gaz liquéfié (31).

6. Procédé selon l'une quelconque des revendications précédentes, dans lequel le solide (29a) ou le gaz liquéfié (31) est comprimé en des pastilles de CO₂ (29b) avant le déchargement.

7. Procédé selon l'une quelconque des revendications précédentes, consistant en outre à :
mélanger le solide (29a, 29b) produit à partir du gaz liquéfié (31) avec un gaz (40) pour former un courant gazeux (28), et
décharger le flux gazeux (28) sur la surface (24) à nettoyer.

8. Dispositif de nettoyage (26) servant à nettoyer des surfaces (24), en particulier des surfaces (24) d'éléments optiques (17), comprenant :
un appareil de fourniture (30) servant à fournir un gaz liquéfié (31) sous forme de CO₂ liquéfié,
un appareil de production (37) servant à produire un solide (29a, 29b) sous forme de neige de CO₂ (29a) à partir du gaz liquéfié (31), de préférence par détente du gaz liquéfié (31)
un appareil de déchargement (27) servant à décharger le solide (29a, 29b) sur la surface (24) à nettoyer,
dans lequel
l'appareil de fourniture (30) comprend au moins un filtre à particules (33) servant à éliminer les particules (P) contenues dans le gaz liquéfié (31),
**caractérisé**
**en ce que** le filtre à particules (33) présente un taux de rétention d'au moins 0,1 µm, de préférence d'au moins 0,05 µm.

9. Dispositif de nettoyage selon la revendication 8, dans lequel un milieu filtrant (36) du filtre à particules (33) est formé d'une matière plastique, de préférence de PTFE, PFA, POM ou PET.

10. Dispositif de nettoyage selon l'une quelconque des revendications 8 ou 9, dans lequel le filtre à particules (33) comprend un boîtier (35), de préférence un boîtier en acier inoxydable, et un élément filtrant (38) qui sont conçus pour une pression (p) d'au moins 45 bars.

11. Dispositif de nettoyage selon l'une quelconque des revendications 8 à 10, dans lequel le filtre à particules (33) est conçu pour un débit volumique (Q) du gaz liquéfié (31) d'au moins 200 ml/min.

12. Dispositif de nettoyage selon l'une quelconque des revendications 8 à 11, dans lequel le filtre à particules (33) comprend un milieu filtrant (36) ayant une surface filtrante (A) d'au moins 0,00625 m² par litre de gaz liquéfié (31).

13. Dispositif de nettoyage selon l'une quelconque des revendications 8 à 12, comprenant en outre :
une pastilleuse (41) servant à comprimer le solide (29a) ou le gaz liquéfié (31) pour former des pastilles de CO₂ (29b).

14. Dispositif de nettoyage selon l'une quelconque des revendications 8 à 13, comprenant en outre :
un appareil de mélange (39) servant à mélanger le solide (29a, 29b) produit à partir du gaz liquéfié (31) avec un gaz (40) pour former un courant gazeux (28), l'appareil de déchargement (27) étant conçu pour décharger le courant gazeux (28) contenant le solide (29a, 29b) sur la surface (24) à nettoyer.

15. Ensemble optique, en particulier appareil de lithographie EUV (1), comprenant :
au moins une surface (24), qui est de préférence formée sur un élément optique (17),
et au moins un dispositif de nettoyage (26) selon l'une quelconque des revendications 8 à 14 pour nettoyer la surface (24).
